# FASCICULE DE BREVET EUROPEEN

(11) **EP 2 304 819 B1**
(45) Date de publication et mention de la délivrance du brevet: **30.11.2011**
(21) Numéro de dépôt: 09802497.9
(22) Date de dépôt: 27.07.2009
(51) Int. Cl.: H01L 45/00

(54) **DISPOSITIF MEMOIRE ET MEMOIRE CBRAM A FIABILITE AMELIOREE**
SPEICHERVORRICHTUNG UND CBRAM-SPEICHER MIT ERHÖHTER ZUVERLÄSSIGKEIT
MEMORY DEVICE AND CBRAM MEMORY HAVING IMPROVED RELIABILITY

(30) Priorité: 29.07.2008 FR 0855219
(43) Date de publication de la demande: 06.04.2011
(73) Titulaire: Commissariat à l'Énergie Atomique et aux Énergies Alternatives, 75015 Paris (FR)
(72) Inventeur: DRESSLER, Cyril, F-38210 Tullins (FR); SOUSA, Véronique, F-38000 Grenoble (FR)
(74) Mandataire: Ilgart, Jean-Christophe
(86) Numéro de dépôt international: PCT/EP2009/059664
(87) Numéro de publication internationale: WO 2010/012683

(56) Documents cités:
- EP-A- 1 630 880
- EP-A- 1 801 897
- WO-A-2007/093126
- WO-A1-2007/091326

## Description

### DOMAINE TECHNIQUE

L'invention concerne le domaine des mémoires réinscriptibles, et plus particulièrement celui des mémoires non volatiles telles que les mémoires de type CBRAM faisant appel à un électrolyte solide.

### ÉTAT DE LA TECHNIQUE ANTÉRIEURE

En fonction des applications et des performances visées, différents types de mémoires sont utilisées. Les mémoires de type SRAM, ou mémoires vives statiques, offrent des temps d'écriture ultra-rapides, requis par exemple lors de calculs par un microprocesseur. L'inconvénient majeur de ces mémoires est qu'elles sont volatiles et que la taille du point mémoire relativement grande ne permet pas d'obtenir une grande capacité de stockage dans un volume raisonnable.

Les mémoires de type DRAM, ou mémoires vives dynamiques, réalisant le stockage de charges électriques dans des capacités, offrent une grande capacité de stockage. Ces mémoires possèdent toutefois des temps d'écriture plus élevés (quelques dizaines de nanosecondes) que ceux des mémoires de type SRAM et sont elles-aussi volatiles, le temps de rétention de l'information étant de l'ordre de quelques dizaines de millisecondes.

Enfin, pour des applications qui nécessitent un stockage de l'information même lorsque la tension est coupée, des mémoires non volatiles de type EEPROM ou FLASH qui réalisent un stockage de charges sur des grilles flottantes de transistors à effet de champ, sont utilisées. Ces mémoires possèdent toutefois des inconvénients :
- temps d'écriture longs (quelques microsecondes), dus au temps nécessaire pour que les électrons passent du canal à la grille flottante du transistor par effet tunnel,
- densité limitée car la réduction de la taille des transistors conduit à une diminution du signal de lecture, c'est-à-dire une baisse de la différence entre les deux états du point mémoire, et une réduction de la durée de rétention de l'information,
- nombre de cycles d'écriture limité (égal à environ 10⁶) car la capacité de rétention de l'information diminue au fur et à mesure des cycles d'écriture à cause de la création de défauts dans l'oxyde de grille des transistors, permettant aux électrons de s'échapper de la grille flottante.

D'autres types de mémoires non volatiles réinscriptibles existent, basés sur des matériaux actifs tels que des matériaux ferroélectriques (mémoires FERAM), magnétiques (mémoires MRAM), à changement de phase (mémoires PC-RAM) ou encore à conduction ionique (mémoires CBRAM).

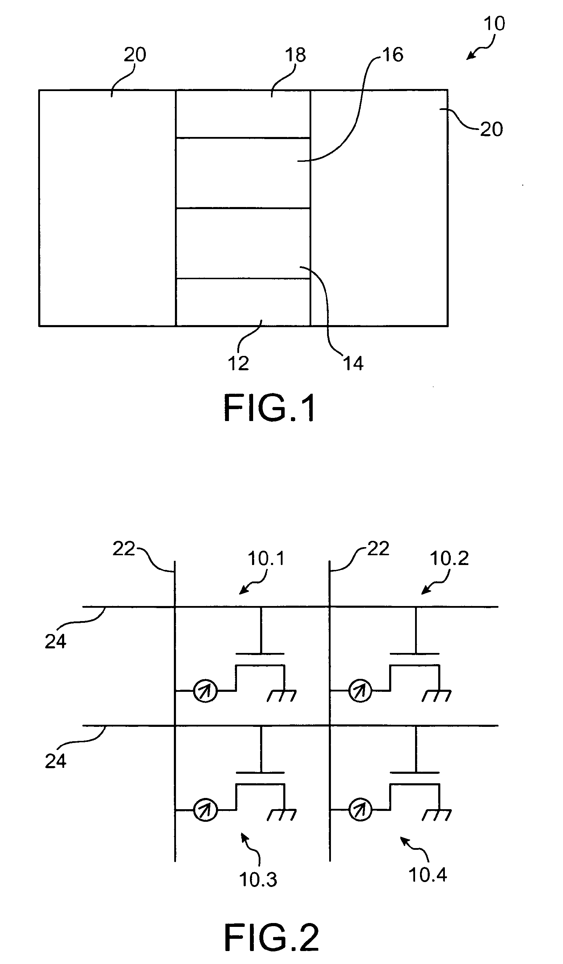

La figure 1 représente un schéma de principe d'un dispositif mémoire 10 de type CBRAM. Ce dispositif mémoire 10 comporte un électrolyte solide 14 à base de chalcogénure dopé, tel que du GeSe, disposé entre une électrode inférieure 12 de nickel, formant une cathode inerte, et une portion de métal ionisable 16 à base d'argent, c'est-à-dire une portion de métal pouvant facilement former des ions métalliques (ici des ions argent Ag²⁺), et formant une anode. Des ions métalliques provenant de la portion de métal ionisable 16 ont été diffusés dans l'électrolyte solide 14 lors du dépôt de cette portion 16 sur l'électrolyte solide 14. Une électrode supérieure 18 est disposée sur la portion de métal ionisable 16. Ces éléments sont isolés électriquement par des portions diélectriques latérales 20 à base de SiO₂ ou de SiN, disposées autour de ces éléments.

Le dispositif mémoire représenté sur la figure 1 forme un point mémoire, c'est-à-dire une cellule mémoire unitaire, d'une mémoire comportant une multitude de ces dispositifs mémoires. La figure 2 représente une matrice d'adressage d'une mémoire de type CBRAM. Cette matrice comporte une pluralité de transistors d'adressage, permettant de contrôler chaque dispositif mémoire de cette mémoire CBRAM. Sur la figure 2, quatre transistors d'adressage 10.1 à 10.4, destinés à piloter quatre dispositifs mémoires, sont représentés. Ces quatre transistors sont reliés électriquement entre eux par des lignes de bits 22 et des lignes de mots 24, permettant d'adresser indépendamment chacun des dispositifs mémoires.

L'état mémoire d'un dispositif mémoire CBRAM résulte de la différence de résistivité électrique entre deux états : ON et OFF. A l'état OFF, les ions métalliques (ici des ions Ag⁺) issus de la portion de métal ionisable 16 sont dispersés dans tout l'électrolyte solide 14. Ainsi, aucun contact électrique n'est établi entre l'anode et la cathode, c'est-à-dire entre la portion de métal ionisable 16 et l'électrode inférieure 12. L'électrolyte solide 14 forme une zone électriquement isolante de grande résistivité entre l'anode 16 et la cathode 12. Une opération d'écriture dans le dispositif mémoire 10 est réalisée en appliquant une différence de potentiel de quelques centaines de microvolts entre l'anode 16 et la cathode 12 sous la forme d'une impulsion de quelques dizaines de nanosecondes. Les ions métalliques Ag⁺ initialement dispersés dans l'électrolyte solide 14 migrent alors vers la cathode 12 pour former un dépôt métallique. Ce dépôt métallique prend la forme de nanofils métalliques, appelés « dendrites », croissant progressivement au sein du milieu électrolytique sous l'effet de la tension appliquée et finissant par établir des ponts de conduction électrique entre l'anode 16 et la cathode 12 : c'est l'état ON. L'électrolyte solide 14 forme alors une zone électriquement conductrice grâce aux nanofils métalliques formés entre l'anode 16 et la cathode 12.

Une opération d'effacement est réalisée en appliquant une différence de potentiel de même intensité et de même durée, mais de signe opposé, entre les électrodes 12 et 18, le dépôt métallique (les nanofils) précédemment formé se « dissolvant » sous forme ionique dans l'électrolyte solide 14, permettant au dispositif mémoire 10 de revenir à l'état OFF.

Un avantage des mémoires CBRAM réside dans le fait que les valeurs des tensions d'écriture nécessaires, inférieures à 1 Volt, sont faibles par rapport à celles des autres types de mémoires non volatiles (EEPROM, MRAM, PCRAM).

Pour obtenir une mémoire de type CBRAM fiable, il est nécessaire de réaliser une distribution homogène du métal ionisable formant les anodes sur les électrolytes solides des différents dispositifs mémoires. Cette distribution homogène est très difficile à obtenir car les ions métalliques Ag⁺ sont très mobiles. On observe généralement une agglomération de particules métalliques provenant de l'anode au niveau de l'électrode inférieure, pouvant conduire à des déformations des couches supérieures et des courts circuits entre les électrodes, et ce d'autant plus que la quantité d'argent déposée est importante. Une mémoire de type CBRAM comporte donc généralement une fiabilité faible due à un certain nombre de points mémoires défectueux.

Le document WO 2007/091326 A1 décrit un dispositif mémoire comportant une électrode électriquement conductrice, une portion d'un matériau de résistivité supérieure à celle du matériau de l'électrode disposée autour de l'électrode, un électrolyte solide et une portion de métal empilés sur l'électrode et la portion de matériau électriquement isolant.

Le rapport entre le coefficient de résistivité électrique du matériau de résistivité supérieure à celle du matériau de l'électrode inerte et le coefficient de résistivité électrique du matériau de l'électrode est égal ou supérieur à 100.

### EXPOSÉ DE L'INVENTION

Un but de la présente invention est de proposer un dispositif mémoire, par exemple destiné à former un point mémoire d'une mémoire de type CBRAM, présentant une fiabilité améliorée par rapport aux dispositifs mémoires de l'art antérieur.

Pour cela, la présente invention propose un dispositif mémoire comportant au moins :
- une électrode à base d'un matériau électriquement conducteur,
- une portion d'au moins un matériau électriquement isolant, ou de résistivité supérieure à celle du matériau de l'électrode, disposée autour et/ou à côté de l'électrode,
- un électrolyte solide empilé sur au moins une partie de l'électrode et de la portion de matériau électriquement isolant, et comportant des ions métalliques issus d'une portion de métal ionisable disposée contre l'électrolyte solide,
le rapport entre le coefficient de résistivité électrique du matériau électriquement isolant ou de résistivité supérieure à celle du matériau de l'électrode, et le coefficient de résistivité électrique du matériau de l'électrode étant égal ou supérieur à environ 100, et le coefficient de conductivité thermique du matériau électriquement isolant étant égal ou supérieur à environ 10 W.m⁻¹.K⁻¹.

La présente invention concerne en outre un dispositif mémoire comportant au moins :
- une électrode inerte, pouvant former une cathode inerte, à base d'un matériau électriquement conducteur,
- une portion d'au moins un matériau de résistivité supérieure à celle du matériau de l'électrode inerte, disposée autour de l'électrode inerte,
- un électrolyte solide disposé sur au moins une partie de l'électrode inerte et de la portion de matériau électriquement isolant, et comportant des ions métalliques issus d'une portion de métal ionisable, pouvant former une électrode active par exemple utilisée en tant qu'anode, disposée sur l'électrolyte solide,
le rapport entre le coefficient de résistivité électrique du matériau de résistivité supérieure à celle du matériau de l'électrode inerte et le coefficient de résistivité électrique du matériau de l'électrode inerte étant égal ou supérieur à environ 100, et le coefficient de conductivité thermique du matériau électriquement isolant étant égal ou supérieur à environ 10 W.m⁻¹.K⁻¹_{.}

Lors de la réalisation d'un dispositif mémoire CBRAM, le métal ionisable est déposé sur une couche, par exemple de chalcogénure, destinée à former l'électrolyte solide. Or, des gradients thermiques ont tendance à apparaitre dans la couche de chalcogénure car cette couche reçoit une certaine quantité d'énergie qui se dissipe sous forme de chaleur, et provoque une élévation de température différente selon la conductivité thermique des zones sur lesquelles se trouve la couche de chalcogénure. Les matériaux chalcogénures ayant de très fort coefficients thermoélectriques, par exemple égales à environ 1 mV/K, ces gradients thermiques peuvent engendrer des différences de potentiel dans la couche de chalcogénure car les zones les plus froides telles que l'électrode inférieure, c'est-à-dire l'électrode inerte, du dispositif, se chargent négativement et attirent ainsi les ions métalliques issus de la portion de métal ionisable.

En choisissant, autour et/ou à côté de l'électrode inférieure, c'est-à-dire de l'électrode inerte, et sous l'électrolyte solide, un matériau électriquement isolant dont le coefficient de conductivité thermique est égal ou supérieur à environ 10 W.m⁻¹.K⁻¹, on améliore considérablement la conductivité thermique du support électriquement isolant sur lequel est déposé l'électrolyte solide, permettant de réduire ou supprimer les gradients thermiques, et donc les différences de potentiels, apparaissant auparavant dans la couche destinée à former l'électrolyte solide lors du dépôt du métal ionisable.

Cette meilleure conductivité thermique, par rapport aux isolants électriques utilisés dans les dispositifs mémoires de l'art antérieure (le SiO₂ a une conductivité thermique égale à environ 1,5 W.m⁻¹. K⁻¹), permet d'empêcher l'agglomération d'ions métalliques dans l'électrolyte solide au niveau de l'électrode inférieure formant l'électrode inerte, réduisant ainsi la topographie au niveau des points mémoires.

Ainsi, on améliore le rendement des mémoires comportant ce type de dispositif mémoire en tant que point mémoire, car beaucoup moins, voir aucun, de points mémoires se retrouvent en court-circuit. De plus, les problèmes technologiques liés au traitement par des procédés de microélectronique de points mémoires ayant une forte topographie sont réduits. La fiabilité de ces mémoires est donc considérablement améliorée.

De plus, on obtient des caractéristiques électriques plus homogènes entre les différents points de la mémoire.

Le terme « inerte » signifie que l'électrode inerte est un contact électrique du dispositif mémoire à partir duquel aucun ion métallique utile au fonctionnement du dispositif n'est diffusé dans l'électrolyte solide, contrairement à la portion de métal ionisable disposée sur l'électrolyte solide dont les ions métalliques qui ont été diffusés dans l'électrolyte solide permettent la formation des dendrites dans l'électrolyte solide, qui est disposé entre l'électrode inerte et la portion de métal ionisable, lors du fonctionnement du dispositif mémoire. Lors de la mise à l'état « on » du dispositif mémoire (état faible résistivité), c'est-à-dire lors de l'écriture d'un état mémoire « 1 » dans le dispositif, l'électrode inerte sert de cathode inerte et la portion de métal ionisable, qui est une électrode active, forme une anode. Lors de l'effacement du point mémoire, c'est-à-dire lors de la mise à l'état « off » (état forte résistivité) du dispositif mémoire, l'électrode inerte forme alors une anode inerte et l'électrode active, c'est-à-dire la portion de métal ionisable, forme une cathode du dispositif mémoire.

L'électrode inerte peut être à base de nickel et/ou de tungstène, et/ou la portion de matériau électriquement isolant peut être à base nitrure de bore et/ou d'alumine, et/ou l'électrolyte solide peut être à base de chalcogénure, et/ou la portion de métal ionisable peut être à base de cuivre et/ou d'argent.

La portion de matériau électriquement isolant peut être un bicouche dont la couche supérieure en contact avec l'électrolyte solide est à base dudit matériau électriquement isolant, et/ou l'épaisseur de la portion de matériau électriquement isolant peut être comprise entre environ 10 nm et 500 nm.

Le dispositif mémoire peut comporter en outre une seconde électrode, ou électrode supérieure, à base d'un matériau électriquement conducteur disposée, ou empilée, au moins sur la portion de métal ionisable.

Le dispositif mémoire peut comporter en outre au moins une seconde portion d'au moins un matériau électriquement isolant disposée autour de l'électrolyte solide et/ou de la portion de métal ionisable et/ou, lorsque le dispositif comporte une électrode supérieure, une troisième portion d'au moins un matériau électriquement isolant disposée autour de ladite électrode supérieure.

La seconde portion de matériau électriquement isolant et/ou la troisième portion de matériau électriquement isolant peut être à base de SiO₂ et/ou de SiN.

L'invention concerne également un procédé de réalisation d'un dispositif mémoire, comportant au moins les étapes de :
a) dépôt et gravure d'un matériau électriquement conducteur sur un substrat semi-conducteur, formant au moins une électrode inerte,
b) réalisation d'une portion d'au moins un matériau électriquement isolant ou de résistivité supérieure à celle du matériau de l'électrode inerte, autour et/ou à côté de l'électrode inerte,
c) dépôt d'une couche de matériau électrolytique sur au moins une partie de l'électrode inerte et de la portion de matériau électriquement isolant,
d) dépôt d'une couche de métal ionisable sur la couche de matériau électrolytique, diffusant des ions métalliques issus dudit métal ionisable dans la couche de matériau électrolytique,
e) gravure des couches de matériau électrolytique et de métal ionisable, formant respectivement un électrolyte solide et une portion de métal ionisable,
le rapport entre le coefficient de résistivité électrique du matériau électriquement isolant ou de résistivité supérieure à celle du matériau de l'électrode inerte, et le coefficient de résistivité électrique du matériau de l'électrode inerte étant égal ou supérieur à environ 100, et le coefficient de conductivité thermique du matériau électriquement isolant étant égal ou supérieur à environ 10 W.m⁻¹.K⁻¹_{.}

L'étape b) de réalisation de la portion de matériau électriquement isolant peut comporter la mise en oeuvre d'un dépôt d'une couche dudit matériau électriquement isolant sur le substrat et l'électrode inerte, puis une planarisation de ladite couche de matériau électriquement isolant avec arrêt sur l'électrode inerte.

Le procédé peut comporter en outre, après l'étape e) de gravure des couches de matériau électrolytique et de métal ionisable, une étape de réalisation d'au moins une seconde portion d'au moins un matériau électriquement isolant autour de l'électrolyte solide et/ou de la portion de métal ionisable.

L'étape de réalisation de la seconde portion de matériau électriquement isolant autour de l'électrolyte solide et/ou de la portion de métal ionisable peut comporter la mise en oeuvre d'un dépôt d'une couche dudit matériau électriquement isolant autour et au-dessus de l'électrolyte solide et/ou de la portion de métal ionisable, puis une planarisation de ladite couche de matériau électriquement isolant avec arrêt sur la portion de métal ionisable.

Le procédé peut comporter en outre, après l'étape e) de gravure des couches de matériau électrolytique et de métal ionisable, une étape de réalisation d'une électrode supérieure à base d'un matériau électriquement conducteur au moins sur la portion de métal ionisable.

Le procédé peut comporter en outre, après l'étape de réalisation de l'électrode supérieure, une étape de réalisation d'au moins une troisième portion de matériau électriquement isolant autour de la seconde électrode.

L'étape de réalisation de la troisième portion de matériau électriquement isolant autour de l'électrode supérieure peut comporter la mise en oeuvre d'un dépôt d'une couche dudit matériau électriquement isolant autour et au-dessus de l'électrode supérieure, puis une planarisation de ladite couche de matériau électriquement isolant avec arrêt sur l'électrode supérieure.

L'invention concerne en outre une mémoire de type de CBRAM, comportant au moins un dispositif mémoire tel que précédemment décrit, formant un point mémoire de ladite mémoire.

Cette mémoire peut comporter en outre au moins un transistor d'adressage reliée électriquement au dispositif mémoire.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un schéma de principe d'une cellule mémoire de type CBRAM selon l'art antérieur,
- la figure 2 représente une matrice d'adressage de points mémoires de type CBRAM,
- les figures 3A à 3I représentent des étapes d'un procédé de réalisation d'un dispositif mémoire, objet de la présente invention, destiné à former un point mémoire d'une mémoire, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

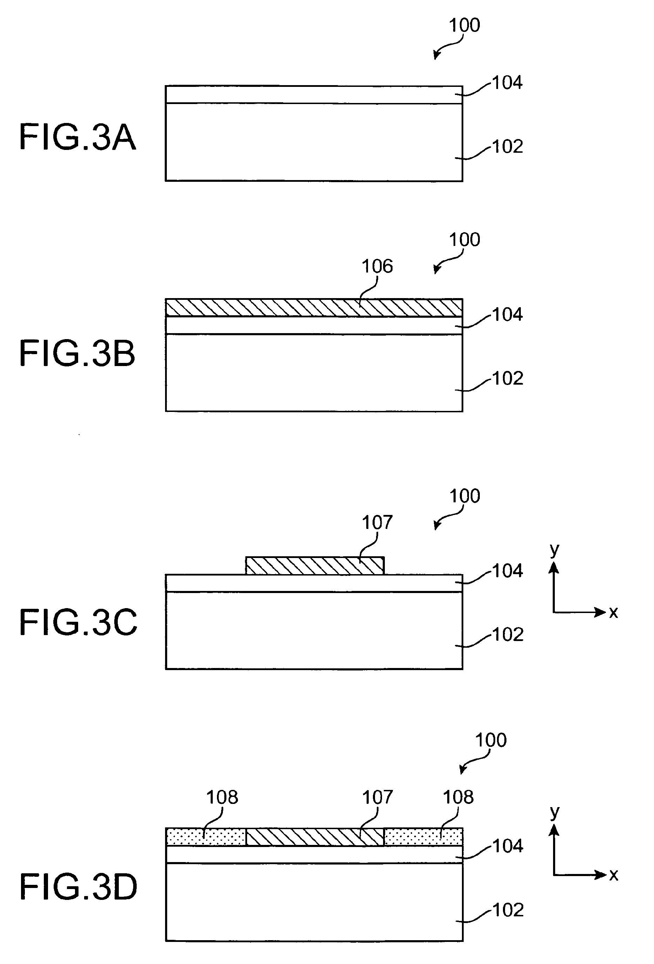

On se réfère aux figures 3A à 3I qui représentent des étapes d'un procédé de réalisation d'un dispositif mémoire 100 selon un mode de réalisation particulier. Ce dispositif 100 est destiné à former un unique point mémoire d'une mémoire 1000. Les figures 3A à 3I ne représentent que la réalisation d'un seul point mémoire, formé par le dispositif mémoire 100. Toutefois, les autres points mémoire de la mémoire 1000 peuvent être réalisés simultanément et/ou de manière analogue au dispositif mémoire 100 décrit sur les figures 3A à 3I.

Comme représenté sur la figure 3A, le dispositif mémoire 100 va être réalisé sur un substrat 102, par exemple à base d'un semi-conducteur tel que du silicium. Afin de réaliser l'adressage du dispositif mémoire 100, au moins un transistor d'adressage, non représenté sur les figures 3A à 3I, est réalisé dans le substrat 102. De manière générale, chaque point mémoire de la mémoire 1000 peut par exemple être contrôlé par au moins un transistor d'adressage réalisé dans ou sur le substrat 102. Une couche d'interconnexions 104 est également formée sur le substrat 102 afin notamment de relier électriquement les transistors d'adressage entre eux et former ainsi des lignes de mots et des lignes de bits de la mémoire 1000.

Sur la figure 3B, on réalise ensuite le dépôt d'une couche de matériau électriquement conducteur 106 sur la couche de connexions 104. Ce matériau électriquement conducteur est par exemple à base d'aluminium, et/ou de cuivre, et/ou avantageusement à base de nickel et/ou de tungstène. Cette couche 106 a par exemple une épaisseur comprise entre environ 10 nm et 500 nm.

Comme représenté sur la figure 3C, on forme ensuite une électrode inférieure, formant une électrode inerte 107 en réalisant une lithographie et une gravure de la couche conductrice 106. Cette électrode inerte 107 a par exemple une largeur (dimension selon l'axe x représenté sur la figure 3C) égale à environ 1 µm.

On réalise ensuite des portions électriquement isolante 108 autour de l'électrode inerte 107. Pour cela, un matériau électriquement isolant est déposé sur l'électrode inerte 107, et autour de cette électrode inerte 107 sur la couche de connexions 104. On réalise alors une planarisation, par exemple de type mécano-chimique (CMP), de cette couche avec arrêt sur l'électrode inerte 107, formant ainsi les portions 108 représentées sur la figure 3D. La largeur totale des portions 108 et de l'électrode inerte 107 est par exemple égale à environ 8 µm. De plus, l'épaisseur des portions 108 est sensiblement égale à celle de l'électrode inerte 107, de part la planarisation réalisée.

Le matériau électriquement isolant utilisé pour réaliser les portions 108 est choisi tel qu'il forme un moins bon conducteur électrique que le matériau de l'électrode inerte 107, de manière à ce que le courant destiné à traverser le dispositif 100 passe essentiellement ou intégralement par l'électrode inerte 107. Les matériaux de l'électrode inerte 107 et des portions 108 sont choisis également tels que le rapport entre le coefficient de résistivité électrique du matériau des portions 108 et le coefficient de résistivité électrique du matériau de l'électrode inerte 107 est de préférence égal ou supérieur à environ 100. Le matériau des portions 108 peut être choisi avantageusement pour que son coefficient de résistivité soit supérieur ou égal à environ 10⁵ ohm.cm, ou avantageusement supérieur ou égal à environ 10¹⁰ ohm.cm, ou en particulier compris entre environ 10¹⁰ ohm.cm et 10²⁰ ohm.cm, par exemple égal à 10¹⁴ ohm.cm. De plus, le matériau des portions 108 est choisi tel que le coefficient de conductivité thermique de ce matériau soit égal ou supérieur à 10 W.m⁻¹.K⁻¹. Ces portions 108 sont par exemple réalisées à partir de nitrure de bore (conductivité thermique égale à environ 60 W.m⁻¹.K⁻¹) et/ou d'alumine (Al₂O₃, conductivité thermique égale à environ 30 W.m⁻¹.K⁻¹). Dans une variante, il est possible que les portions 108 soient formées à partir d'un bicouche de matériaux, le matériau de la couche supérieure (la couche inférieure étant celle en contact avec la couche de connexions 104) étant un matériau remplissant les conditions de conductivité thermique et d'isolation électrique décrites ci-dessus. La couche inférieure peut être à base de SiO₂ et/ou de SiN, et/ou de tout autre matériau électriquement isolant.

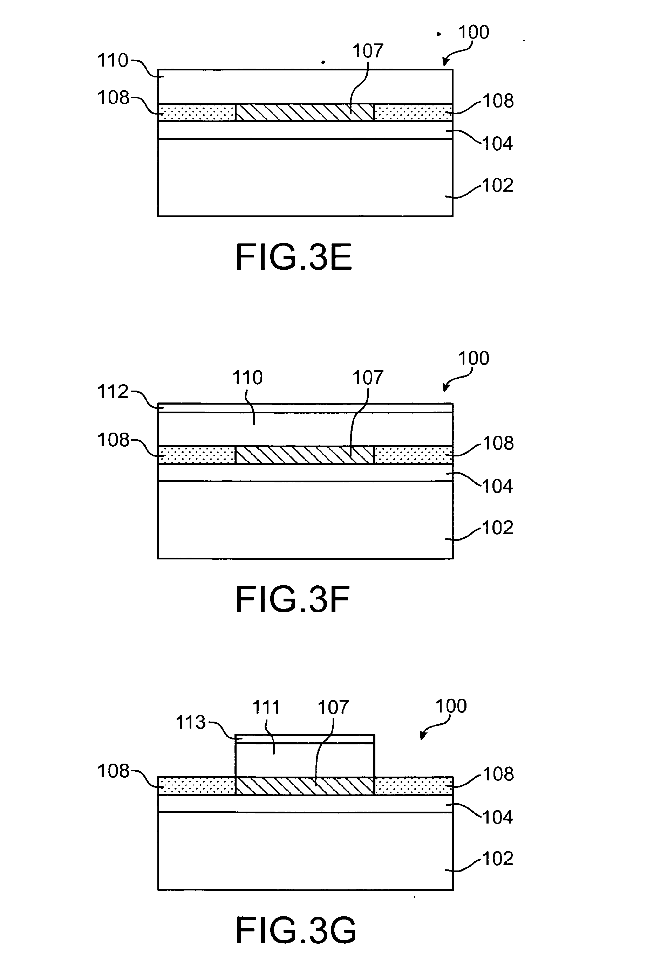

Comme représenté sur la figure 3E, on dépose ensuite une couche 110 destinée à la réalisation d'un électrolyte solide. Cette couche 110 est par exemple à base d'un chalcogénure. On entend par chalcogénure un alliage à base d'au moins un élément chalcogène (élément de la colonne VI du tableau périodique des éléments), c'est-à-dire de l'oxygène, du soufre, du sélénium, du tellure ou du polonium, et un élément plus électropositif, par exemple un élément de la colonne IV ou V du tableau périodique des éléments tel que de l'arsenic, de l'antimoine ou du bismuth pour les éléments de la colonne IV, ou du germanium, de l'étain ou du plomb pour les éléments de la colonne V. Le chalcogénure utilisé peut donc être majoritairement à base de GeSe, et/ou de GeS, et/ou de GeTe, et/ou de AsS et/ou de AsSe. On réalise ensuite le dépôt d'une couche de métal ionisable 112 sur la couche 110 (figure 3F). Ce métal ionisable est par exemple de l'argent et/ou du cuivre et/ou du zinc. L'épaisseur de l'électrolyte solide peut être avantageusement comprise entre environ 10 nm et 500 nm, et en particulier entre environ 20 nm et 180 nm, et par exemple égale à environ 50 nm. L'épaisseur de la couche de métal ionisable peut être avantageusement comprise entre environ 2 nm et 100 nm, et avantageusement comprise entre environ 5 nm et 40 nm, par exemple égale à environ 15 nm.

Lors du dépôt de la couche de métal ionisable 112 sur la couche de chalcogénure 110, des ions métalliques issus de la couche de métal ionisable 112 se diffusent dans la couche de chalcogénure 110. Du fait que les portions 108 soient à base d'un matériau dont le coefficient de conductivité thermique soit égal ou supérieur à environ 10 W.m⁻¹.K⁻¹, on obtient sur la surface formée par les portions 108 et l'électrode inerte 107, sur laquelle est déposée la couche de chalcogénure 110, un gradient thermique plus homogène sur l'ensemble de cette surface. Ainsi, les ions métalliques se répartissent de manière homogène dans l'ensemble de la couche de chalcogénure 110. La concentration ionique dans la couche de chalcogénure 110 est notamment sensiblement similaire au niveau de l'électrode inerte 107 et au niveau des portions électriquement isolantes 108.

De plus, en réalisant des portions 108 de matériau électriquement isolant d'épaisseur égale ou supérieure à environ 10 nm, on évite tout risque de fuite de courant, lors du fonctionnement du dispositif mémoire 100, entre l'électrode inerte 107 et les portions 108 d'une part, et d'autre part on réalise un bon écoulement de la chaleur lors du dépôt de la couche de métal ionisable 112. De plus, l'épaisseur des portions isolantes 108 est ici choisie inférieure à environ 500 nm pour éviter les problèmes de contraintes mécaniques induites sur le dispositif 100 et les problèmes de topologie.

On réalise ensuite une lithographie et une gravure des couches 110 et 112 précédemment déposées, formant ainsi un électrolyte solide 111 et une portion de métal ionisable 113, formant par exemple l'anode du dispositif mémoire 100 lorsque l'électrode inerte 107 forme la cathode du dispositif mémoire 100 (figure 3G).

Le chalcogénure déposé peut être intrinsèquement dopé. Il est également possible de mettre en oeuvre une étape de dopage, par exemple par traitement thermique ou rayonnement UV, de cette couche de chalcogénure 110 ou de l'électrolyte solide 111. Dans le cas d'un dopage par traitement thermique, le dispositif 100 est traité thermiquement après dépôt des couches 110 et 112. La température de ce traitement thermique est judicieusement choisie de façon à permettre la diffusion du métal ionisable dans le chalcogénure. La température de traitement thermique peut avantageusement être choisie entre environ 200°C et 400°C. Dans le cas d'une étape de dopage par rayonnement UV (ou photodissolution), le dispositif 100 est soumis à un rayonnement UV après dépôt des couches 110 et 112. Dans ce cas, l'épaisseur de la couche de métal ionisable 112 est faible pour permettre aux UV d'atteindre la couche de chalcogénure 110. Dans le cas où la quantité de métal ionisable voulue est importante, il est possible de réaliser la photodissolution du métal en plusieurs étapes : dépôt d'une fine épaisseur de métal ionisable puis photodissolution, dépôt d'une seconde couche de métal ionisable puis photodissolution, répétés autant de fois que nécessaire. On entend par fine couche de métal ionisable une couche d'épaisseur avantageusement comprise entre environ 1 nm et 40 nm.

De plus, il est également possible d'augmenter la concentration en ions métallique issus de la couche de métal ionisable 112 dans la couche de chalcogénure 110 en réalisant un traitement thermique ou un rayonnement UV sur la couche de métal ionisable 112. La concentration de métal ionisable dans le chalcogénure peut être comprise entre environ 15% et 50%. Une gamme de concentrations de métal ionisable dans le chalcogénure se situe avantageusement entre environ 25% et 35%, par exemple égale à environ 30%.

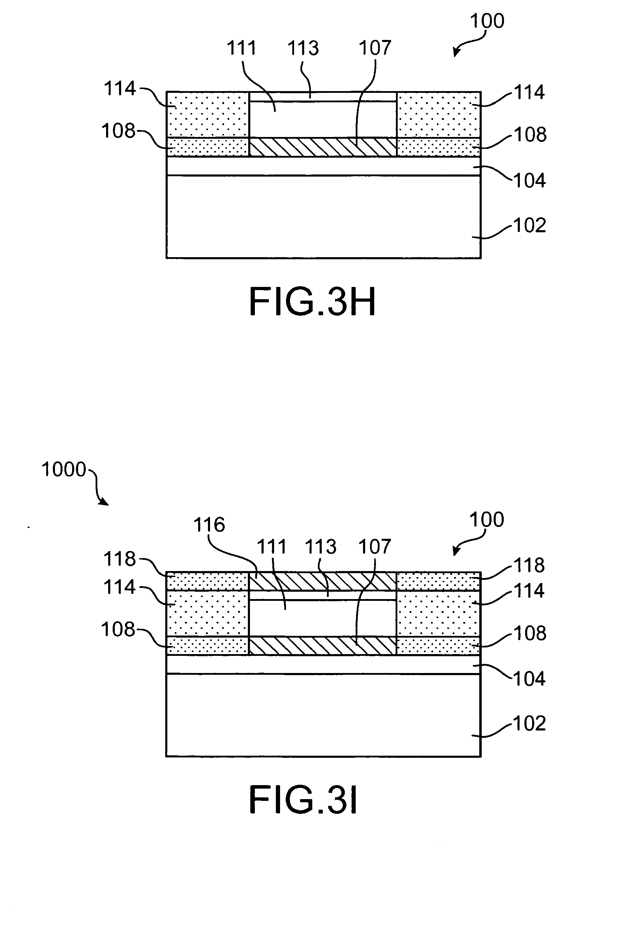

Comme représenté sur la figure 3H, on réalise ensuite le dépôt d'une couche de matériau électriquement isolant, par exemple à base de SiO₂ et/ou de SiN, sur les portions 108 ainsi que sur la portion de métal ionisable 113. Une planarisation de cette couche de matériau est ensuite réalisée, avec arrêt sur la portion de métal ionisable 113, formant des secondes portions 114 de matériau électriquement isolant.

Enfin, de manière analogue à la réalisation de l'électrode inerte 107, on réalise une électrode supérieure 116, qui sert ici de contact électrique, en déposant un matériau électriquement conducteur, par exemple du nickel et/ou du tungstène, sur la portion de métal ionisable 113, qui forme l'électrode active du dispositif, et sur les secondes portions 114 de matériau électriquement isolant. On grave ensuite ce matériau électriquement conducteur pour former l'électrode supérieure 116. Une couche de matériau électriquement isolant tel que du SiN et/ou du SiO₂, est alors déposée sur cette électrode supérieure 116 et sur les secondes portions 114 de matériau électriquement isolant, puis planarisée avec arrêt sur l'électrode supérieure 116, formant ainsi des troisièmes portions 118 de matériau électriquement isolant (figure 3I).

De manière générale, les différents éléments du dispositif mémoire 100 pourront être réalisés en couche mince, c'est-à-dire réalisés à partir de couches dont l'épaisseur est inférieure ou égale à environ 500 nm. Les couches à partir desquelles les éléments du dispositif mémoire 100 sont réalisés peuvent être déposées par PVD (dépôt physique en phase vapeur), CVD (dépôt chimique en phase vapeur), MOCVD (dépôt chimique en phase vapeur métal-organique), ou encore par électrolyse.

## Revendications

1. Dispositif mémoire (100) comportant au moins :
- une électrode inerte (107) à base d'un matériau électriquement conducteur,
- une portion (108) d'au moins un matériau de résistivité supérieure à celle du matériau de l'électrode inerte (107), disposée autour de l'électrode inerte (107),
- un électrolyte solide (111) disposé sur au moins une partie de l'électrode inerte (107) et de la portion (108) de matériau électriquement isolant, et comportant des ions métalliques issus d'une portion de métal ionisable (113) disposée sur l'électrolyte solide (111),
le rapport entre le coefficient de résistivité électrique du matériau de résistivité supérieure à celle du matériau de l'électrode inerte (107) et le coefficient de résistivité électrique du matériau de l'électrode inerte (107) étant égal ou supérieur à environ 100, et le coefficient de conductivité thermique du matériau électriquement isolant étant égal ou supérieur à environ 10 W.m⁻¹.K⁻¹.

2. Dispositif mémoire (100) selon la revendication 1, dans lequel l'électrode inerte (107) est à base de nickel et/ou de tungstène, et/ou la portion (108) de matériau électriquement isolant est à base nitrure de bore et/ou d'alumine, et/ou l'électrolyte solide (111) est à base de chalcogénure, et/ou la portion de métal ionisable (113) est à base de cuivre et/ou d'argent.

3. Dispositif mémoire (100) selon l'une des revendications précédentes, dans lequel la portion (108) de matériau électriquement isolant est un bicouche dont la couche supérieure en contact avec l'électrolyte solide (111) est à base dudit matériau électriquement isolant, et/ou l'épaisseur de la portion (108) de matériau électriquement isolant est comprise entre environ 10 nm et 500 nm.

4. Dispositif mémoire (100) selon l'une des revendications précédentes, comportant en outre une électrode supérieure (116) à base d'un matériau électriquement conducteur disposée au moins sur la portion de métal ionisable (113).

5. Dispositif mémoire (100) selon l'une des revendications précédentes, comportant en outre au moins une seconde portion (114) d'au moins un matériau électriquement isolant disposée autour de l'électrolyte solide (111) et/ou de la portion de métal ionisable (113) et/ou, lorsque le dispositif (100) comporte une électrode supérieure (116), une troisième portion (118) d'au moins un matériau électriquement isolant disposée autour de ladite électrode supérieure (116).

6. Dispositif mémoire (100) selon la revendication 5, dans lequel la seconde portion (114) de matériau électriquement isolant et/ou la troisième portion (118) de matériau électriquement isolant est à base de SiO₂ et/ou de SiN.

7. Procédé de réalisation d'un dispositif mémoire (100), comportant au moins les étapes de :
a) dépôt et gravure d'un matériau électriquement conducteur (106) sur un substrat semi-conducteur (102, 104), formant au moins une électrode inerte (107),
b) réalisation d'une portion (108) d'au moins un matériau de résistivité supérieure à celle du matériau de l'électrode inerte (107) autour de l'électrode inerte (107),
c) dépôt d'une couche de matériau électrolytique (110) sur au moins une partie de l'électrode inerte (107) et de la portion (108) de matériau électriquement isolant,
d) dépôt d'une couche de métal ionisable (112) sur la couche de matériau électrolytique (110), diffusant des ions métalliques issus dudit métal ionisable (112) dans la couche de matériau électrolytique (110),
e) gravure des couches de matériau électrolytique (110) et de métal ionisable (112), formant respectivement un électrolyte solide (111) et une portion de métal ionisable (113),
le rapport entre le coefficient de résistivité électrique du matériau de résistivité supérieure à celle du matériau de l'électrode inerte (107) et le coefficient de résistivité électrique du matériau de l'électrode inerte (107) étant égal ou supérieur à environ 100, et le coefficient de conductivité thermique du matériau électriquement isolant étant égal ou supérieur à environ 10 W.m-¹.K⁻¹.

8. Procédé de réalisation selon la revendication 7, dans lequel l'étape b) de réalisation de la portion (108) de matériau électriquement isolant comportant la mise en oeuvre d'un dépôt d'une couche dudit matériau électriquement isolant sur le substrat (102, 104) et l'électrode inerte (107), puis une planarisation de ladite couche de matériau électriquement isolant avec arrêt sur l'électrode inerte (107).

9. Procédé de réalisation selon l'une des revendications 7 ou 8, comportant en outre, après l'étape e) de gravure des couches de matériau électrolytique (110) et de métal ionisable (112), une étape de réalisation d'au moins une seconde portion (114) d'au moins un matériau électriquement isolant autour de l'électrolyte solide (111) et/ou de la portion de métal ionisable (113).

10. Procédé de réalisation selon la revendication 9, dans lequel l'étape de réalisation de la seconde portion (114) de matériau électriquement isolant autour de l'électrolyte solide (111) et/ou de la portion de métal ionisable (113) comportant la mise en oeuvre d'un dépôt d'une couche dudit matériau électriquement isolant autour et au-dessus de l'électrolyte solide (111) et/ou de la portion de métal ionisable (113), puis une planarisation de ladite couche de matériau électriquement isolant avec arrêt sur la portion de métal ionisable (113).

11. Procédé de réalisation selon l'une des revendications 7 à 10, comportant en outre, après l'étape e) de gravure des couches de matériau électrolytique (110) et de métal ionisable (112), une étape de réalisation d'une électrode supérieure (116) à base d'un matériau électriquement conducteur au moins sur la portion de métal ionisable (113).

12. Procédé de réalisation selon la revendication 11, comportant en outre, après l'étape de réalisation de l'électrode supérieure (116), une étape de réalisation d'au moins une troisième portion (118) de matériau électriquement isolant autour de la seconde électrode (116).

13. Procédé de réalisation selon la revendication 12, dans lequel l'étape de réalisation de la troisième portion (118) de matériau électriquement isolant autour de l'électrode supérieure (116) comporte la mise en oeuvre d'un dépôt d'une couche dudit matériau électriquement isolant autour et au-dessus de l'électrode supérieure (116), puis une planarisation de ladite couche de matériau électriquement isolant avec arrêt sur l'électrode supérieure (116).

14. Mémoire (1000) de type de CBRAM, comportant au moins un dispositif mémoire (100) selon l'une des revendications 1 à 6, formant un point mémoire de ladite mémoire (1000).

15. Mémoire (1000) selon la revendication 14, comportant en outre au moins un transistor d'adressage relié électriquement au dispositif mémoire (100).

## Claims

1. Memory device (100) including at least:
- one inert electrode (107) based on an electrically conductive material,
- a part (108) of at least one material of resistivity higher than that of the material of the inert electrode (107), positioned around the inert electrode (107),
- a solid electrolyte (111) positioned on at least one part of the inert electrode (107) and of the part of electrically insulating material (108), and including metal ions originating from an ionisable metal part (113) positioned on the solid electrolyte (111),
where the ratio between the coefficient of electrical resistivity of the material of resistivity higher than that of the material of the inert electrode (107) and the coefficient of electrical resistivity of the material of the inert electrode (107) is equal to or higher than approximately 100, and the coefficient of thermal conductivity of the electrically insulating material is equal to or higher than approximately 10 W.M⁻¹.K⁻¹_{.}

2. Memory device (100) according to claim 1, in which the inert electrode (107) is based on nickel and/or tungsten, and/or the part (108) of electrically insulating material is based on boron nitride and/or alumina, and/or the solid electrolyte (111) is based on chalcogenide, and/or the ionisable metal part (113) is based on copper and/or silver.

3. Memory device (100) according to one of the previous claims, in which the part (108) of electrically insulating material is a bilayer, the upper layer of which, in contact with the solid electrolyte (111), based on said electrically insulating material, and/or the thickness of the part (108) of electrically insulating material is between approximately 10 nm and 500 nm.

4. Memory device (100) according to one of the previous claims, also including an upper electrode (116) based on an electrically conductive material positioned at least on the ionisable metal part (113).

5. Memory device (100) according to one of the previous claims, also including at least a second part (114) of at least one electrically insulating material positioned around the solid electrolyte (111) and/or the ionisable metal part (113) and/or, when the device (100) includes an upper electrode (116), a third part (118) of at least one electrically insulating material positioned around the said upper electrode (116).

6. Memory device (100) according to claim 5, in which the second part (114) of the electrically insulating material and/or the third part (118) of electrically insulating material is based on SiO₂ and/or SiN.

7. Method for producing a memory device (100), including at least the following steps:
a) deposit and etching of an electrically conductive material (106) on a semiconductor substrate (102, 104), forming at least one inert electrode (107),
b) production of a part (108) of at least one material of resistivity higher than that of the material of the inert electrode (107), around the inert electrode (107),
c) deposit of a layer of electrolytic material (110) on at least one part of the inert electrode (107) and of the part (108) of electrically insulating material,
d) deposit of a layer of ionisable metal (112) on the layer of electrolytic material (110), diffusing the metal ions originating from said ionisable metal (112) in the layer of electrolytic material (110),
e) etching of the layers of electrolytic material (110) and of ionisable metal (112), respectively forming a solid electrolyte (111) and an ionisable metal part (113),
where the ratio between the coefficient of electrical resistivity of the material of resistivity higher than that of the material of the inert electrode (107) and the coefficient of electrical resistivity of the material of the inert electrode (107) is equal to or higher than approximately 100, and the coefficient of thermal conductivity of the electrically insulating material is equal to or higher than approximately 10 W.m⁻¹.K⁻¹.

8. Method of production according to claim 7, in which step b) of production of the part (108) of electrically insulating material includes the use of a deposit of a layer of the said electrically insulating material on the substrate (102, 104) and the inert electrode (107), followed by a planarisation of the said layer of electrically insulating material with stoppage on the inert electrode (107).

9. Method of production according to one of the claims 7 or 8, also including, after step e) of etching of the layers of electrolytic material (110) and of ionisable metal (112), a step of production of at least a second part (114) of at least one electrically insulating material around the solid electrolyte (111) and/or of the ionisable metal part (113).

10. Method of production according to claim 9, in which the step of production of the second part (114) of electrically insulating material around the solid electrolyte (111) and/or of the ionisable metal part (113) includes the use of a deposit of a layer of the said electrically insulating material around and above the solid electrolyte (111) and/or the ionisable metal part (113), followed by a planarisation of the said layer of electrically insulating material with stoppage on the ionisable metal part (113).

11. Method of production according to one of the claims 7 to 10, also including, after step e) of etching of the layers of electrolytic material (110) and of ionisable metal (112), a step of production of an upper electrode (116) comprising an electrically conductive material, at least on the ionisable metal part (113).

12. Method of production according to claim 11, also including, after the step of production of the upper electrode (116), a step of production of at least a third part (118) of electrically insulating material around the second electrode (116).

13. Method of production according to claim 12, in which the step of production of the third part (118) of electrically insulating material around the upper electrode (116) includes the use of a deposit of a layer of the said electrically insulating material around and above the upper electrode (116), followed by a planarisation of the said layer of electrically insulating material with stoppage on the upper electrode (116).

14. Memory (1000) of the CBRAM type, including at least one memory device (100) according to one of the claims 1 to 6, forming a memory point of the said memory (1000).

15. Memory (1000) according to claim 14, also including at least one addressing transistor electrically linked to the memory device (100).

## Patentansprüche

1. Speichervorrichtung (100), wenigstens umfassend:
- eine inerte Elektrode (107) auf der Basis eines elektrisch leitfähigen Materials,
- einen um die inerte Elektrode (107) angeordneten Teil (108) aus einem Material mit einer höheren Resistivität als derjenigen des Materials der inerten Elektrode (107),
- einen auf wenigstens einem Teilstück der inerten Elektrode (107) und dem Teil (108) aus elektrisch isolierenden Material angeordneten Festelektrolyten (111), der von einem auf dem Festelektrolyten (111) angeordneten ionisierbaren Metallteil (113) stammende Metallionen enthält,
wobei das Verhältnis zwischen dem elektrischen Resistivitätskoeffizienten des Materials von höherer Resistivität als derjenigen des Materials der inerten Elektrode (107) und dem elektrischen Resistivitätskoeffizienten des Materials der inerten Elektrode (107) gleich oder höher als ungefähr 100 ist, und der Wärmeleitfähigkeitskoeffizient des elektrisch isolierenden Materials gleich oder höher als ungefähr 10 W. m⁻¹. K⁻¹ ist.

2. Speichervorrichtung (100) nach Anspruch 1, bei der die inerte Elektrode (107) auf Nickel und/oder Wolfram basiert, und/oder der Teil (108) aus elektrisch isolierendem Material auf Bornitrid und/oder Aluminiumoxid basiert, und/oder der Festelektrolyten (111) auf einem Chalcogenid basiert, und/oder der ionisierbare Metallteil (113) auf Kupfer und/oder Silber basiert.

3. Speichervorrichtung (100) nach einem der vorhergehenden Ansprüche, bei der der Teil (108) aus elektrisch isolierendem Material eine Doppelschicht ist, deren obere Schicht mit Kontakt mit dem Festelektrolyten (111) auf dem genannten elektrisch isolierenden Material basiert, und/oder die Dicke des Teils (108) aus elektrisch isolierendem Material zwischen ungefähr 10 nm und 500 nm enthalten ist.

4. Speichervorrichtung (100) nach einem der vorhergehenden Ansprüche, mit außerdem einer oberen Elektrode (116) auf der Basis eines wenigstens auf dem ionisierbaren Metallteil (113) angeordneten elektrisch leitfähigen Materials.

5. Speichervorrichtung (100) nach einem der vorhergehenden Ansprüche, mit außerdem einem zweiten Teil (114) aus wenigstens einem elektrisch isolierenden Material, angeordnet um den Festelektrolyten (111) und/oder den ionisierbaren Metallteil (113) herum und/oder, wenn die Vorrichtung (100) eine obere Elektrode (116) umfasst, einem dritten Teil (118) aus wenigstens einem elektrisch isolierenden Material, angeordnet um die genannte obere Elektrode (116) herum.

6. Speichervorrichtung (100) nach Anspruch 5, bei der der zweite Teil (114) aus elektrisch isolierendem Material und/oder der dritte Teil (118) aus elektrisch isolierendem Material auf SiO₂ und/oder SiN basiert.

7. Verfahren zur Herstellung einer Speichervorrichtung (100), die wenigstens die folgenden Schritte umfasst:
a) Abscheidung und Ätzung eines elektrisch leitfähigen Materials (106) auf einem Halbleitersubstrat (102, 104), um wenigstens eine inerte Elektrode (107) auszubilden,
b) Realisierung eines Teils (108) aus wenigstens einem Material mit einer höheren Resistivität als derjenigen des Materials der inerten Elektrode (107) um die inerte Elektrode (107) herum,
c) Abscheidung einer Schicht aus elektrolytischem Material (110) auf wenigstens einem Teil der inerten Elektrode (107) und dem Teil (108) aus elektrisch isolierendem Material,
d) Abscheidung einer Schicht aus ionisierbarem Metall (112) auf der Schicht aus elektrolytischem Material (110), so dass von dem ionisierbaren Metall (112) stammende Metallionen in die Schicht aus elektrolytischem Material (110) diffundieren,
e) Ätzung der Schichten aus elektrolytischem Material (110) und aus ionisierbarem Metall (112), um jeweils einen Festelektrolyten (111) und einen Teil aus ionisierbarem Metall (113) auszubilden,
wobei das Verhältnis zwischen dem elektrischen Resistivitätskoeffizienten des Materials von höherer Resistivität als derjenigen des Materials der inerten Elektrode (107) und dem elektrischen Resistivitätskoeffizienten des Materials der inerten Elektrode (107) gleich oder höher als ungefähr 100 ist, und der Wärmeleitfähigkeitskoeffizient des elektrisch isolierenden Materials gleich oder höher als ungefähr 10 W.m⁻¹.K⁻¹ ist.

8. Herstellungsverfahren nach Anspruch 7, bei dem der Schritt b) zur Realisierung des Teils (108) aus elektrisch isolierendem Material das Abscheiden einer Schicht aus dem genannten elektrisch isolierenden Material auf dem Substrat (102, 104) und der inerten Elektrode (107) umfasst, sodann eine Planarisierung der genannten Schicht aus elektrisch isolierendem Material mit Stopp auf der inerten Elektrode (107).

9. Herstellungsverfahren nach einem der Ansprüche 7 oder 8, außerdem umfassend - nach dem Schritt e) zur Ätzung der Schichten aus elektrolytischem Material (110) und aus ionisierbarem Metall (112) -, einen Schritt zur Realisierung wenigstens eines zweiten Teils (114) aus wenigstens einem elektrisch isolierenden Material um den Festelektrolyten (111) und/oder den ionisierbaren Metallteil (113) herum.

10. Herstellungsverfahren nach Anspruch 9, bei dem der Schritt zur Realisierung des zweiten Teils (114) aus elektrisch isolierendem Material um den Festelektrolyten (111) und/oder den Teil aus ionisierbarem Metall (113) herum das Abscheiden einer Schicht aus dem genannten elektrisch isolierenden Material, auf dem Festelektrolyten (111) und/oder dem ionisierbaren Metallteil (113) und drum herum umfasst, sodann eine Planarisierung der genannten Schicht aus elektrisch isolierendem Material mit Stopp auf dem ionsierbaren Metallteil (113).

11. Herstellungsverfahren nach einem der Ansprüche 7 bis 10, außerdem umfassend - nach dem Schritt e) zur Ätzung der Schichten aus elektrolytischem Material (110) und aus ionisierbarem Metall (112) -, einen Schritt zur Realisierung einer oberen Elektrode (116) auf der Basis eines elektrisch leitfähigen Materials wenigstens auf dem ionsierbaren Metallteil (113).

12. Herstelfungsverfahren nach Anspruch 11, außerdem umfassend - nach dem Schritt zur Realisierung der oberen Elektrode (116) -, einen Schritt zur Realisierung wenigstens eines dritten Teils (118) aus elektrisch isolierendem Material um die zweite Elektrode (116) herum.

13. Herstellungsverfahren nach Anspruch 12, bei dem der Schritt zur Realisierung des dritten Teils (118) aus elektrisch isolierendem Material um die obere Elektrode (116) herum das Abscheiden einer Schicht aus dem genannten elektrisch isolierenden Material auf der oberen Elektrode (116) und drum herum umfasst, sodann eine Planarisierung der genannten Schicht aus elektrisch isolierendem Material mit Stopp auf der oberen Elektrode (116).

14. Speicher (1000) des CBRAM-Typs mit wenigstens einer Speichervorrichtung (100) nach einem der Ansprüche 1 bis 6, die einen Speicherpunkt des genannten Speichers (1000) bildet.

15. Speicher (1000) mit wenigstens einem elektrisch mit der Speichervorrichtung (100) verbundenen Adressierungstransistor.
